(19) Europäisches Patentamt
European Patent Office
Office européen des brevets

(11) **EP 1 964 272 B1**

(12) **FASCICULE DE BREVET EUROPEEN**

(45) Date de publication et mention
de la délivrance du brevet:
**24.11.2010 Bulletin 2010/47**

(21) Numéro de dépôt: **06841317.8**

(22) Date de dépôt: **11.12.2006**

(51) Int Cl.:
*H03M 9/00* (2006.01)     *H04L 7/02* (2006.01)

(86) Numéro de dépôt international:
**PCT/EP2006/069505**

(87) Numéro de publication internationale:
**WO 2007/071574 (28.06.2007 Gazette 2007/26)**

(54) **INTERFACE DE TRANSMISSION DE DONNEES NUMERIQUES SYNCHRONES**

SYNCHRONE DIGITALDATENÜBERTRAGUNGSSCHNITTSTELLE

SYNCHRONOUS DIGITAL DATA TRANSMISSION INTERFACE

(84) Etats contractants désignés:
**DE GB**

(30) Priorité: **20.12.2005 FR 0512960**

(43) Date de publication de la demande:
**03.09.2008 Bulletin 2008/36**

(73) Titulaire: **Thales**
**92200 Neuilly Sur Seine (FR)**

(72) Inventeurs:
• **SONTAG, Yves**
**F-33200 Bordeaux (FR)**
• **JARDIN, Laurent**
**F-33127 Saint Jean D'Illac (FR)**

(74) Mandataire: **Bréda, Jean-Marc et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
**EP-A- 0 397 198     US-A- 5 905 769**

• **WIDMER A X ET AL: "SINGLE-CHIP 4 X 500-MBD CMOS TRANSCEIVER" IEEE JOURNAL OF SOLID-STATE CIRCUITS, IEEE SERVICE CENTER, PISCATAWAY, NJ, US, vol. 31, no. 12, 1 décembre 1996 (1996-12-01), pages 2004-2013, XP000691821 ISSN: 0018-9200**

## Description

Le domaine de l'invention est celui des interfaces de transmission de signaux d'entrée numériques binaires synchrones comportant un désérialisateur, encore appelé « deserializer » en terminologie anglo-saxonne. Ces interfaces sont plus connues sous l'acronyme anglo-saxon SDI signifiant Serial Digital Interface et plus généralement, on appelle signaux SDI les signaux issus de ces interfaces.

Dans un grand nombre d'applications nécessitant le traitement de données numériques à haut débit, la transmission des données entre deux unités de traitement se fait par des liaisons série, ce qui permet de réduire le câblage et de simplifier la connectique entre les différentes unités de traitement. Par contre, le traitement des données est réalisé en parallèle par les unités de traitement pour des raisons d'efficacité.

Pour assurer les conversions parallèle-série et série-parallèle, on utilise des convertisseurs appelés sérialisateurs ou désérialisateurs qui convertissent les signaux série en signaux parallèle et réciproquement. En général, les deux fonctions sont rassemblées dans un circuit intégré unique appelé SERDES, abréviation anglo-saxonne de SERializer-DESerializer.

Les SERDES sont particulièrement utilisés pour la transmission de signaux numériques vidéo. Les signaux vidéo sont régis par des normes de définition et de transmission. Les principaux organismes à l'origine de ces normes sont le CCIR, Comité Consultatif International des Radiocommunications et le SMPTE, Society of Motion Picture Television Engineers.

Certaines normes comme la SMPTE 259 qui est la version de transmission sérialisée de la norme vidéo SMPTE 125 impose de respecter strictement le caractère synchrone de la transmission des signaux vidéo. Les signaux sont dits synchrones lorsque la fréquence de transmission du signal est un multiple exact de la fréquence pixel, qui est elle-même un multiple exact de la fréquence ligne, laquelle est un multiple exact de la fréquence trame. Cette obligation entraîne des complications matérielles importantes pour des coffrets électroniques ayant à recevoir ou à transmettre de tels signaux comme, par exemple, les coffrets de commutation. En effet, la transmission de signaux synchrones implique que l'horloge du désérialisateur ait une fréquence parfaitement identique à celle du signal vidéo. Pour résoudre cette difficulté, il existe principalement deux grands types de solution.

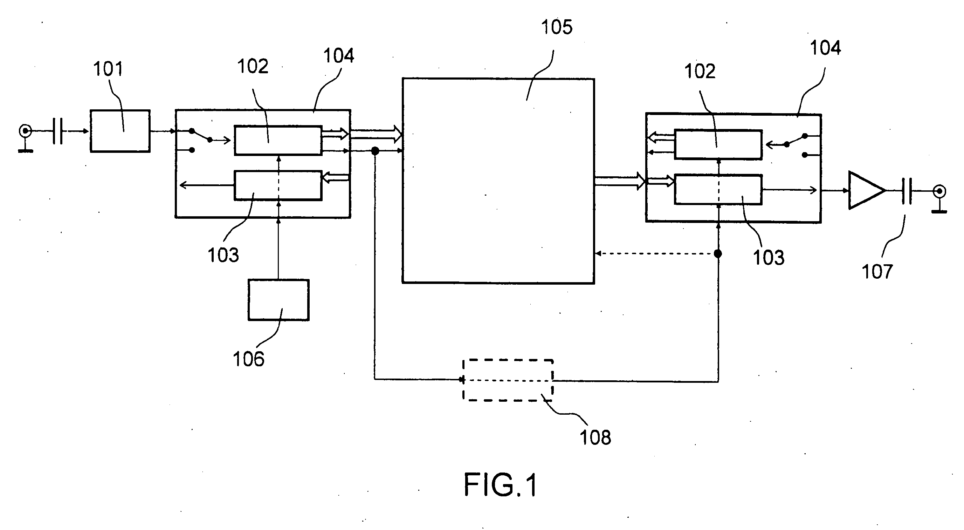

Le premier type de solution est illustré en figure 1 qui représente un ensemble électronique comprenant successivement 5 éléments principaux :

- Une première liaison 101 de transmission de signaux vidéo • numériques série haut débit ;
- Un désérialisateur 102 inclus classiquement dans un premier composant SERDES 104 qui transforme le signal série d'entrée en signaux parallèles ;

- Une unité de traitement électronique 105 des signaux parallèles ;
- Un sérialisateur 103 inclus classiquement dans un second composant SERDES 104 qui transforme les signaux parallèles en signal série de sortie;
- Une seconde liaison 107 de transmission de signaux vidéo numériques série haut débit.

Sur cette figure et sur les deux suivantes, les conventions suivantes ont été adoptées :

- Les signaux série sont représentés par des flèches en traits noirs ;
- Les signaux parallèle sont représentés par des flèches blanches épaisses.

Dans ce type de configuration, on utilise un circuit de récupération d'horloge à boucle de phase analogique inclus dans le premier composant SERDES qui est utilisé uniquement en récepteur. Il utilise un oscillateur à fréquence fixe comme horloge de référence. Son circuit de récupération d'horloge à boucle de phase analogique délivre un signal d'horloge synchrone de la source à la fréquence pixel. Tous les circuits en aval concourant à la régénération d'une sortie SDI dépendant du signal d'entrée utilisent alors ce signal d'horloge. Si cette horloge possède trop de jitter, il est possible d'insérer une boucle de phase additionnelle ayant une fréquence de coupure très basse et un oscillateur très performant de type VCXO, acronyme anglo-saxon signifiant Voltage Controlled Crystal Oscillator. Cette option est illustrée sur la figure 1 où l'oscillateur 108 est représenté par un rectangle en traits pointillés. Le sérialisateur du premier SERDES utilisé en réception ne peut pas être utilisé en émission puisque son horloge interne n'est pas synchrone de la fréquence du signal d'entrée. On doit donc utiliser, comme illustré en figure 1, un second SERDES pour la mise en série du signal série de sortie.

Cette solution présente l'inconvénient de nécessiter des composants SERDES spécifiques capables de fonctionner avec les « patterns pathologiques » de la norme SMPTE 259. On entend par « patterns pathologiques » toute succession importante du même état logique comme, par exemple, une succession de 20 « 0 », ladite succession est appelée généralement « run length ».

Les fabricants de composants de type FPGA, acronyme anglo-saxon signifiant « Field Programmable Gate Array » proposent des composants SERDES à très haut débit, dimensionnés pour des débits égaux ou supérieurs à 622 Mbauds. Leurs circuits de récupération d'horloge à boucle de phase analogique ne sont pas compatibles d'applications à plus bas débit.

A plus bas débit, les composants spécifiques SERDES présentent les inconvénients de ne plus pouvoir être intégrés dans des composants de type FPGA et d'avoir une consommation et un encombrement importants.

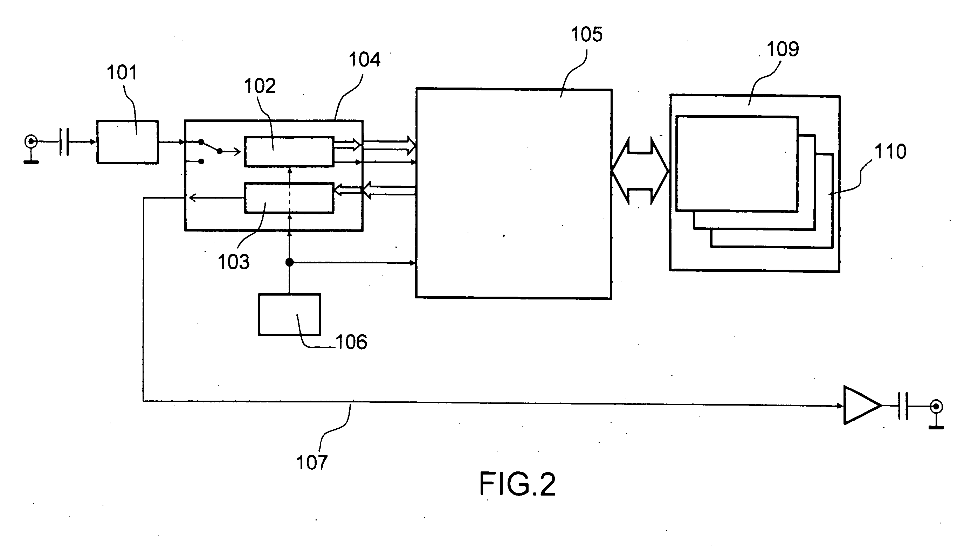

Le second type de solution est illustré en figure 2 qui représente un ensemble électronique comprenant 5 éléments principaux :

- Une première liaison 101 de transmission de signaux vidéo numériques série haut débit ;
- Une seconde liaison de transmission 107 de signaux vidéo numériques série haut débit.
- Un composant SERDES 104 unique comprenant :

  ○ un désérialisateur 102 qui transforme le signal série d'entrée en signaux parallèle d'entrée et o un sérialisateur 103 qui transforme les signaux parallèle de sortie en signal série de sortie ;

- Une unité de traitement électronique 105 des signaux parallèles ;
- Un convertisseur 109 de fréquence trame encore appelé en terminologie anglo-saxonne « Field Rate Converter ».

Le principe de fonctionnement consiste à régénérer complètement un signal vidéo SDI à l'aide d'un convertisseur 109 de fréquence trame. Ce convertisseur utilise des mémoires de trames 110 encore appelées en terminologie anglo-saxonne « Frame Buffers» selon des modes qui peuvent être soit « triple page », soit « FIFO », acronyme signifiant « First In - First Out ». Les circuits en aval de ce convertisseur utilisent un signal d'horloge généré dans l'équipement et toutes les fréquences pixel, ligne et trame du signal de sortie sont des divisions exactes de la fréquence de ce signal d'horloge. Ainsi, le caractère parfaitement synchrone du signal de sortie est respecté. Cette seconde solution est coûteuse et complexe sur le plan matériel. Le stockage en mémoires « Frame Buffers» ajoute nécessairement un temps de latence correspondant à la durée de deux trames ou de deux images dans la chaîne de transmission. Ce temps de latence peut s'avérer inacceptable lorsque l'information vidéo doit être utilisée en temps réel.

La société ALTERA propose une solution permettant de résoudre ce problème de synchronisation de l'horloge. Cette solution est basée sur le principe du suréchantillonnage asynchrone encore appelé en terminologie anglo-saxonne « oversampling ». L'horloge du désérialisateur est forcée sur son entrée de fréquence de référence au lieu de s'asservir sur la fréquence du signal d'entrée.

Celui-ci est suréchantillonné généralement avec un rapport nominal de 5. Par exemple, si le débit du signal d'entrée est de 270 Mbauds, le désérialisateur fonctionne avec une fréquence d'échantillonnage de 1350 Mbauds. La désérialisation peut se faire, par exemple, sur 10 bits du signal d'entrée. Par conséquent, si le suréchantillonnage est dans un rapport 5, pour chaque mot parallèle de 10 bits, en moyenne 2 échantillons du signal sont extraits. Cependant, comme la fréquence de référence du désérialisateur est issue d'un oscillateur qui n'est pas synchrone, il se produit un glissement de phase qui nécessite de capturer périodiquement soit un seul échantillon, soit trois selon le signe de l'écart de fréquence. Les échantillons sont stockés dans un registre tampon dont on extrait un mot de largeur fixe. Le rythme auquel les 10 échantillons sont prélevés est donc de 27 mégahertz. Pour décoder le signal vidéo, il ne reste plus qu'à réaliser des fonctions classiques pour ce type de transmission :

- décoder le bus selon le code pseudo-aléatoire de la norme, opération encore appelée « descrambler » ;
- reconnaître les messages de synchronisation vidéo ;
- retrouver la phase des mots, opération encore appelée « word boundaries synchronisation ».

Cette solution permet d'intégrer un grand nombre d'interfaces dans un seul circuit tout en conservant une faible consommation électrique. Mais les fréquences du signal d'entrée sont perdues. La fréquence du signal récupéré est bien en moyenne de 27 mégahertz. Mais, par rapport au signal d'horloge de 135 mégahertz synchrone de la fréquence d'horloge du désérialisateur, si la période du signal vaut très fréquemment la durée de 5 échantillons, elle peut également valoir 4 ou 6 durées d'échantillons de temps en temps. Par conséquent, le jitter introduit est trop important pour retransmettre un signal synchrone. Il est possible d'introduire une boucle de phase pour filtrer la fréquence des signaux de sortie et restituer une horloge parfaitement régulière, mais la réalisation électronique de cette boucle de phase se révèle particulièrement ardue.

Les techniques de récupération d'horloge à boucle de phase analogique et de suréchantillonnage sont habituellement contradictoires, la première est utilisée pour les hauts débits, proches des limites de vitesse des composants, la seconde est utilisée pour les bas débits.

Le brevet US 5 905 769 décrit une interface de transmission comprenant un désérialisateur fonctionnant en suréchantillonnage. Cependant, la fréquence de sortie des signaux parallèles n'est pas asservie sur la fréquence de transmission du signal d'entrée série.

Le dispositif selon l'invention combine désérialisation et récupération de phase par suréchantillonnage, encore appelé oversampling avec une boucle d'asservissement de fréquence. Il permet de traiter, à moindre coût, des signaux synchrones sans présenter les inconvénients des méthodes précédentes.

Plus précisément, l'invention a pour objet une interface de transmission d'un signal d'entrée numérique synchrone composé de bits émis en série à une fréquence de transmission égale à un premier multiple entier M d'une première fréquence d'horloge, ladite interface comprenant au moins un désérialisateur (201) fonctionnant en sur-échantillonnage à une fréquence de suréchantillonnage sensiblement égale à un multiple entier N de la fréquence de transmission et fournissant des échantillons numériques de sortie en parallèle de chaque bit, les échantillons de sortie étant émis à une seconde fréquence d'horloge, multiple entier N d'une troisième fréquence, ladite troisième fréquence étant sensiblement égale à la première fréquence, chaque bit échantillonné étant composé sensiblement de N échantillons, un signal d'entrée série donnant M signaux parallèles émis à ladite troisième fréquence,

**caractérisé en ce que** ladite interface comporte un dispositif électronique d'asservissement disposé de telle façon que la fréquence d'horloge de suréchantillonnage soit constamment asservie sur la fréquence du signal d'entrée, ledit dispositif comprenant :

- Des moyens de comptage (202, 203, 204) couplés dudit déserialisateur et agencés pour détecter le nombre d'échantillons composant chaque bit échantillonné ;
- Des moyens d'incrémentation-décrémentation (208, 209, 210) couplés auxdits moyens de comptage (202, 203, 204) ;
- Des moyens de génération de fréquence (211) couplés auxdits moyens d'incrémentation-décrémentation (208, 209, 210) pour générer un signal d'horloge ayant une fréquence égale à ladite seconde fréquence d'horloge, agencés de façon que la seconde fréquence d'horloge est augmentée lorsque ledit nombre d'échantillons est inférieur au multiple entier N et diminuée lorsque ledit nombre d'échantillons est supérieur à N ;
- des moyens de multiplication par M de fréquence (212) commandé par le signal d'horloge issu desdits moyens de génération de fréquence (211) pour générer ladite fréquence de suréchantillonage.

Avantageusement, les moyens de comptage comportent :

- Des moyens de détection des changements d'état des échantillons numériques de sortie ;
- Des moyens de pointage permettant, parmi une succession d'échantillons, d'extraire un échantillon représentatif d'un bit ;
- Des moyens de comparaison des positions relatives des changements d'état des échantillons et des positions des moyens de pointage.

Avantageusement, les moyens d'incrémentation-décrémentation comprennent essentiellement et successivement un compteur numérique, un convertisseur analogique-numérique, une électronique d'amplification et de filtrage, le signal issu de ladite électronique commandant la tension de contrôle de l'oscillateur qui génère le signal d'horloge de référence du désérialisateur.

Avantageusement, l'interface est agencée de façon que l'écart de fréquence relatif ΔF/F maximal entre la troisième fréquence et la première fréquence est inférieur à l'inverse du produit du multiple entier N par le nombre de « run-length » du signal d'entrée.

L'invention sera mieux comprise et d'autres avantages apparaîtront à la lecture de la description qui va suivre donnée à titre non limitatif et grâce aux figures annexées parmi lesquelles :

- La figure 1 représente un premier ensemble électronique selon l'art antérieur permettant le traitement de signaux numériques sérialisés par une unité de traitement fonctionnant en parallèle ;
- La figure 2 représente un second ensemble électronique selon l'art antérieur permettant également le traitement de signaux numériques sérialisés par une unité de traitement fonctionnant en parallèle ;
- La figure 3 représente une interface de transmission d'un signal d'entrée numérique selon l'invention.

Comme il a été dit, le coeur de l'invention repose sur 3 principes :

- Suréchantillonnage du signal série ;
- Détermination du nombre d'échantillons composant chaque bit du signal échantillonné ;
- Asservissement de la fréquence d'horloge d'échantillonnage en fonction du nombre d'échantillons détecté.

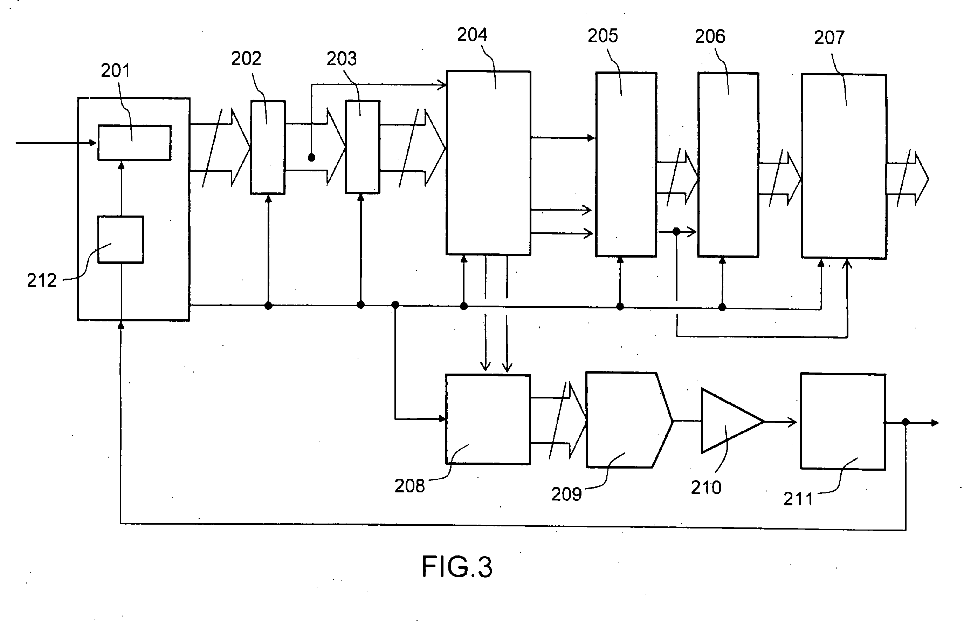

Il existe, bien entendu, différentes réalisations électroniques permettant d'atteindre ces fonctions. La figure 3 est un exemple de synoptique d'une interface de transmission de signaux d'entrée numériques binaires synchrones selon l'invention.

Ce dispositif comprend :

- Un désérialisateur 201;
- Un premier et un second registre de stockage identiques 202 et 203 ;
- Des moyens d'indexation et de comparaison 204 ;
- Un troisième registre de stockage 205 ;
- Un quatrième registre de stockage 206 ;
- Des fonctions de traitement classiques des signaux parallèle 207;
- Des moyens d'incrémentation-décrémentation de la troisième fréquence d'horloge comprenant un compteur 208, un convertisseur digital-analogique 209, un amplificateur 210 et un oscillateur 211 ;
- Un multiplicateur de fréquence d'horloge 212 commandé par le signal d'horloge issu de l'oscillateur 211.

Pour faciliter la compréhension du fonctionnement de l'interface, on choisit pour les principaux paramètres les valeurs suivantes qui correspondent à des valeurs typiques de signaux vidéo :

- Fréquence pixel du signal numérique d'entrée sérialisé : 270 Mbps (mégabits par seconde) ;

- Fréquence de suréchantillonnage du désérialisateur : sensiblement égale à 5 fois ce débit, soit environ 1350 mégahertz. N vaut donc 5 ;
- Nombre M d'échantillons parallèles à la sortie du désérialisateur : 10 émis à 135 mégahertz ;
- Fréquence des signaux numériques parallèle de sortie : 27 mégahertz.

Bien entendu, le dispositif peut fonctionner de façon équivalente avec d'autres valeurs de paramètres.

Le signal d'entrée numérique série est désérialisé par le désérialisateur 201. A la sortie du désérialisateur 201, des flux de 10 échantillons parallèles sont émis à une cadence voisine de 135 mégahertz et sont stockés dans le premier registre 202.

Le second registre 203 de la figure 3 permet de prendre en compte au moins un onzième échantillon succédant aux 10 échantillons de chaque flux. Cet onzième échantillon peut se révéler nécessaire si certaines opérations logiques réalisées sur les dix échantillons nécessitent deux échantillons successifs. C'est le cas, notamment, quand les moyens de comparaison 204 comprennent des portes logiques réalisant la fonction « ou exclusif ». Dans ce cas, le onzième échantillon est utile pour réaliser l'opération logique avec le dixième échantillon.

Ces 10 signaux parallèles échantillonnés, compte-tenu du suréchantillonnage, correspondent donc à environ 2 bits du signal d'entrée, chaque bit étant composé d'environ 5 échantillons successifs.

Les moyens d'indexation et de comparaison 204 comprennent un pointeur électronique qui est normalement indexé sur l'échantillon central de ces 5 échantillons. Il est intéressant d'adopter cette disposition de façon à diminuer le taux d'erreur. En effet, sur les 5 échantillons représentant un bit du signal, les échantillons extrêmes peuvent être bruités et on conserve ainsi une marge d'erreur de pointage d'un échantillon.

Les moyens d'indexation et de comparaison 204 comprennent également des moyens de détection des changements d'état de ces échantillons. Pour réaliser cette fonction, on peut par exemple utiliser une batterie de portes logiques réalisant la fonction « ou exclusif », encore appelées XOR. On sait que la sortie d'une porte XOR est au niveau logique 1 que si une et une seule de ces deux entrées est au niveau logique 1. Par ce moyen, il est aisé de déterminer les changements d'état qui se traduiront, à la sortie des portes XOR, par des niveaux logiques « 1 ».

On compare alors par des moyens électroniques classiques la position relative des changements d'état des échantillons et la positions des moyens de pointage. Deux cas peuvent se présenter :

- La position relative correspond à la position attendue. Cela signifie qu'un bit échantillonné comprend 5 échantillons et que, par conséquent, la fréquence d'échantillonnage est égale à exactement 5 fois la fréquence du signal numérique d'entrée. Dans ce cas, on ne change ni la position du pointeur ni la fréquence d'échantillonnage et on passe à l'analyse du bit suivant. L'échantillon pointé est stocké dans le troisième registre 205 à 12 bits à la cadence de 27 mégahertz et se remplit au fur et à mesure de l'arrivée des échantillons retenus.
- La position relative ne correspond pas à la position attendue. La variation de phase est due au glissement de fréquence entre la première et les seconde et troisième fréquences. Cela signifie qu'un bit échantillonné ne comprend pas 5 échantillons et que, par conséquent, la fréquence d'échantillonnage n'est plus égale à exactement 5 fois la fréquence du signal numérique d'entrée. Dans ce cas, trois actions sont entreprises :

  ○ La position du pointeur est indexé soit positivement soit négativement selon le sens du déphasage de façon à le recentrer sur l'échantillon central d'un bit échantillonné ;
  ○ Ce signal d'indexation qui peut être positif (position dite UP) ou négatif (position dite DOWN) commande les moyens d'incrémentation-décrémentation de la fréquence d'horloge du signal de référence à 135 mégahertz qui pilote la fréquence de suréchantillonage.
  ○ L'échantillon pointé est stocké dans le troisième registre 205 à 12 bits.

Lorsque le registre 205 à 12 bits contient au moins 10 échantillons, les 10 plus anciens échantillons sont extraits pour être stockés dans la quatrième registre 206 qui comporte bien 10 bits en parallèle émis à la cadence de 27 mégahertz correspondant à 10 bits série du signal d'entrée émis à la cadence de 270 mbps. La fonction de désérialisation est donc bien réalisée à la bonne fréquence puisque l'horloge d'échantillonnage est constamment asservie sur la fréquence du signal d'entrée.

Bien entendu, le dispositif électronique peut comporter d'autres fonctions comme la gestion du pointeur. En effet, si le pointeur se décale toujours dans le même sens sur plusieurs bits successifs, il arrivera nécessairement en limite de registre. Dans ce cas, il faut le réinitialiser et veiller que pendant cette réinitialisation, le bon nombre de bits est bien pris en compte selon que le pointeur est descendu jusqu'en bas du registre ou monté jusqu'en haut du registre.

Les signaux UP et DOWN permettent d'incrémenter ou de décrémenter un compteur 208 dont la sortie produit une tension analogique par l'intermédiaire d'un convertisseur digital analogique 209 appelé encore DAC, acronyme anglo-saxon signifiant Digital Analogic Counter. A travers un circuit d'amplification et de filtrage 210, cette tension contrôle la fréquence de l'oscillateur 211. Cette fréquence vaut environ 135 mégahertz. Les différentes composantes électroniques du système sont pilotées par cette fréquence d'horloge. Cette fréquence est multipliée par 10 par un multiplicateur de fréquence d'horloge 212. La fréquence d'horloge obtenue donne la fréquence d'échantillonnage du désérialisateur qui vaut donc 1350 mégahertz.

On réalise ainsi un asservissement de l'oscillateur 211 sur la première fréquence d'horloge du signal. Quand la boucle d'asservissement est accrochée, le glissement de fréquence est donc annulé.

L'interface de transmission selon l'invention doit être capable de fonctionner convenablement avec tous types de configurations de signaux série. Lorsqu'un signal présente une succession de plusieurs bits au même niveau logique, succession que l'on nomme en terminologie anglo-saxonne « run length », il est important que la fréquence d'échantillonnage soit suffisamment proche d'un multiple entier de la fréquence d'horloge du signal initial de façon que la période séparant deux signaux d'incrémentation ou de désincrémentation soit plus grande que la durée d'un « run length ». Ainsi, si la durée d'un « run length » vaut $N_X$ bits et si on note $\Delta F/F$ l'écart de fréquence relatif entre la fréquence d'horloge du signal d'entrée et la fréquence d'horloge du signal de référence, on démontre que :

$$\Delta F/F < 1/(N.N_X)$$

Par exemple, dans le cas de la norme SMPTE 259, le « run length » vaut 20 bits, et si le nombre d'échantillons vaut 5, alors $\Delta F/F$ doit être inférieure à 1%.

Le convertisseur analogique-numérique DAC 209 doit posséder un nombre suffisant de bits de codage et sa vitesse de codage doit au moins être égal à la fréquence d'échantillonnage multipliée par l'écart de fréquence relatif $\Delta F/F$. On peut, bien entendu, utiliser un DAC vidéo qui fonctionne à des fréquences beaucoup plus élevées.

Tout signal issu d'un dispositif de transmission possède un TIE, acronyme anglo-saxon signifiant « Time Interval Error » qui correspond à l'écart de position des transitions du signal numérique par rapport à la position idéale. Par principe même, dans le dispositif selon l'invention, cet écart vaut une période d'échantillonnage, soit un Nième de la période du signal série. Il faut veiller que cet écart soit compatible des normes de transmission retenue. Dans l'exemple cité plus haut, sa valeur vaut $\pm$ 0.2 U.I. et est juste compatible de la norme SMPTE 259. Cependant, ce jitter systématique est de fréquence très basse et n'a pas d'impacts pour les équipements vidéo numériques utilisés.

## Revendications

**1.** Interface de transmission d'un signal d'entrée numérique synchrone composé de bits émis en série à une fréquence de transmission égale à un premier multiple entier M d'une première fréquence d'horloge, ladite interface comprenant au moins un désérialisateur (201) fonctionnant en sur-échantillonnage à une fréquence de suréchantillonnage sensiblement égale à un multiple entier N de la fréquence de transmission et fournissant des échantillons numériques de sortie en parallèle de chaque bit, les échantillons de sortie étant émis à une seconde fréquence d'horloge, multiple entier N d'une troisième fréquence, ladite troisième fréquence étant sensiblement égale à la première fréquence, chaque bit échantillonné étant composé sensiblement de N échantillons, un signal d'entrée série donnant M signaux parallèles émis à ladite troisième fréquence, **caractérisé en ce que** ladite interface comporte un dispositif électronique d'asservissement disposé de telle façon que la fréquence d'horloge de suréchantillonnage soit constamment asservie sur la fréquence du signal d'entrée, ledit dispositif comprenant :

- Des moyens de comptage (202, 203, 204) couplés audit désérialisateur et agencés pour détecter le nombre d'échantillons composant chaque bit échantillonné ;
- Des moyens d'incrémentation-décrémentation (208, 209, 210) couplés auxdits moyens de comptage (202, 203, 204) ;
- Des moyens de génération de fréquence (211) couplés auxdits moyens d'incrémentation-décrémentation (208, 209, 210) pour générer un signal d'horloge ayant une fréquence égale à ladite seconde fréquence d'horloge, agencés de façon que la seconde fréquence d'horloge est augmentée lorsque ledit nombre d'échantillons est inférieur au multiple entier N et diminuée lorsque ledit nombre d'échantillons est supérieur à N ;
- des moyens de multiplication par M de fréquence (212) commandé par le signal d'horloge issu desdits moyens de génération de fréquence (211) pour générer ladite fréquence de suréchantillonage.

**2.** Interface de transmission selon la revendication 1, **caractérisé en ce que** les moyens de comptage (204) comportent :

• Des moyens de détection des changements d'état des échantillons numériques de sortie ;
• Des moyens de pointage permettant, parmi une succession d'échantillons, d'extraire un échantillon représentatif d'un bit ;
• Des moyens de comparaison des positions relatives des changements d'état des échantillons et des positions des moyens de pointage.

**3.** Interface de transmission selon la revendication 1, **caractérisé en ce que** les moyens d'incrémentation-décrémentation comprennent essentiellement et successivement un compteur numérique (208), un convertisseur analogique-numérique (209), une électronique d'amplification et de filtrage (210), le signal issu de ladite électronique commandant la tension de contrôle d'un oscillateur (211) qui génère le signal d'horloge de référence.

4.  Interface de transmission selon la revendication 1, **caractérisé en ce que** l'interface est dimensionnée de façon que l'écart de fréquence relatif ΔF/F maximal entre la troisième fréquence et la première fréquence est inférieur à l'inverse du produit du multiple entier N par le nombre de « run-length » du signal d'entrée.

**Claims**

1.  An interface for transmission of a synchronous digital input signal composed of bits emitted in series at a transmission frequency equal to a first integral multiple M of a first clock frequency, said interface comprising at least one deserialiser (201) operating by over-sampling at an over-sampling frequency essentially equal to an integral multiple N of the transmission frequency and providing digital output samples of each bit in parallel, the output samples being emitted at a second clock frequency which is an integral multiple N of a third frequency, said third frequency being essentially equal to the first frequency, each sampled bit being essentially composed of N samples, a serial input signal providing M parallel signals emitted at said third frequency,
    **characterised in that** said interface includes an electronic control device arranged so that the over-sampling clock frequency is constantly controlled at the frequency of the input signal, said device including:

    - counting means (202, 203, 204) coupled to said deserialiser and arranged to detect the number of samples composing each sampled bit;
    - incrementation-decrementation means (208, 209, 210) coupled to said counting means (202, 203, 204);
    - frequency generating means (211) coupled to said incrementation-decrementation means (208, 209, 210) for generating a clock signal having a frequency equal to said second clock frequency, arranged so that the second clock frequency is increased when said number of samples is smaller than the integral multiple N and decreased when said number of samples is higher than N;
    - means of multiplying by M the frequency (212) controlled by the clock signal originating from said frequency generating means (211) in order to generate said over-sampling frequency.

2.  The transmission interface according to claim 1, **characterised in that** the counting means (204) include:

    - means of detecting changes in the status of the output digital samples;
    - means of locating a sample, said means allowing the extraction of a sample representing a bit, from a succession of samples;
    - means of comparing the relative positions of the status changes of the samples and the positions of the locating means.

3.  The transmission interface according to claim 1, **characterised in that** the incrementation-decrementation means essentially and successively include a digital counter (208), an analogue-digital converter (209), amplification and filtering electronics (210), the signal originating from said electronics controlling the control voltage of an oscillator (211) which generates the reference clock signal.

4.  The transmission interface according to claim 1, **characterised in that** the interface is dimensioned so that the maximum relative frequency deviation ΔF/F between the third frequency and the first frequency is smaller than the inverse of the product of the multiplication of the integral multiple N by the number of "run-lengths" of the input signal.

**Patentansprüche**

1.  Schnittstelle zur Übertragung eines synchronen digitalen Eingangssignals bestehend aus Bits, die in Serie mit einer Übertragungsfrequenz emittiert werden, die gleich einem ersten ganzzahligen Vielfachen M einer ersten Taktfrequenz ist, wobei die Schnittstelle wenigstens einen Deserialisator (201) umfasst, der durch Überabtastung mit einer Überabtastungsfrequenz arbeitet, die im Wesentlichen gleich einem ganzzahligen Vielfachen N der Übertragungsfrequenz ist, und der digitale Ausgangssamples jedes Bits parallel erzeugt, wobei die Ausgangssamples mit einer zweiten Taktfrequenz, einem ganzzahligen Vielfachen N einer dritten Frequenz, emittiert werden, wobei die dritte Frequenz im Wesentlichen gleich der ersten Frequenz ist, wobei jedes abgetastete Bit im Wesentlichen aus N Samples zusammengesetzt ist, wobei ein serielles Eingangssignal M parallele Signale liefert, die mit der dritten Frequenz emittiert werden,
    **dadurch gekennzeichnet, dass** die Schnittstelle ein elektronisches Regelgerät mit der Aufgabe umfasst, die Überabtastungstaktfrequenz konstant auf die Frequenz des Eingangssignals zu regeln, wobei das Gerät Folgendes beinhaltet:

- Zählmittel (202, 203, 204), die mit dem Deserialisator gekoppelt sind und angeordnet sind, um die Anzahl der Samples zu erfassen, aus denen sich jedes abgetastete Bit zusammensetzt;
- Inkrementations-Dekrementationsmittel (208, 209, 210), die mit den Zählmitteln (202, 203, 204) gekoppelt sind;
- Frequenzerzeugungsmittel (211), die mit den Inkrementations-Dekrementationsmitteln (208, 209, 210) zum Erzeugen eines Taktsignals mit einer der zweiten Taktfrequenz gleichen Frequenz gekoppelt sind, und angeordnet sind, um die zweite Taktfrequenz zu erhöhen, wenn die Zahl der Samples kleiner ist als das ganzzahlige Vielfache N, und sie zu verringern, wenn die Zahl der Samples größer als N ist;
- Mittel zum Multiplizieren der Frequenz (212) mit M, gesteuert durch das Taktsignal von dem Frequenzerzeugungsmittel (211), um die Überabtastungsfrequenz zu erzeugen.

2. Übertragungsschnittstelle nach Anspruch 1, **dadurch gekennzeichnet, dass** die Zählmittel (204) Folgendes umfassen:

- Mittel zum Erkennen von Änderungen des Status der digitalen Ausgangssamples;
- Ortungsmittel, um aus einer Folge von Samples ein ein Bit repräsentierendes Sample zu extrahieren;
- Mittel zum Vergleichen der relativen Positionen der Statusänderungen der Samples und der Positionen der Ortungsmittel.

3. Übertragungsschnittstelle nach Anspruch 1, **dadurch gekennzeichnet, dass** die Inkrementations-Dekrementationsmittel im Wesentlichen und aufeinander folgend Folgendes umfassen: einen digitalen Zähler (208), einen Analog-Digital-Wandler (209), Verstärkungs- und Filterungselektronik (210), wobei das von der Elektronik kommende Signal die Steuerspannung eines Oszillators (211) regelt, der das Referenztaktsignal erzeugt.

4. Übertragungsschnittstelle nach Anspruch 1, **dadurch gekennzeichnet, dass** die Schnittstelle so dimensioniert ist, dass die maximale relative Frequenzabweichung $\Delta F/F$ zwischen der dritten Frequenz und der ersten Frequenz kleiner als die Umkehr des Produkts aus der Multiplikation des ganzzahligen Vielfachen N mit der "Lauflängen"-Zahl des Eingangssignals ist.

FIG.1

FIG.2

EP 1 964 272 B1

FIG.3

EP 1 964 272 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5905769 A